# FASCICULE DE BREVET EUROPEEN

(11) **EP 4 162 522 B1**
(45) Date de publication et mention de la délivrance du brevet: **12.06.2024**
(21) Numéro de dépôt: 21731232.1
(22) Date de dépôt: 26.04.2021
(51) Int. Cl.: H01L 21/683

(54) **SUBSTRAT TEMPORAIRE DEMONTABLE COMPATIBLE AVEC DE TRES HAUTES TEMPERATURES ET PROCEDE DE TRANSFERT D'UNE COUCHE UTILE A PARTIR DUDIT SUBSTRAT**
ABNEHMBARES TEMPORÄRES SUBSTRAT MIT SEHR HOHEN TEMPERATUREN UND VERFAHREN ZUR ÜBERTRAGUNG EINER ARBEITSSCHICHT VON DIESEM SUBSTRAT
DETACHABLE TEMPORARY SUBSTRATE COMPATIBLE WITH VERY HIGH TEMPERATURES AND PROCESS FOR TRANSFERRING A WORKING LAYER FROM SAID SUBSTRATE

(30) Priorité: 09.06.2020 FR 2006023
(43) Date de publication de la demande: 12.04.2023
(73) Titulaire: SOITEC, 38190 Bernin (FR)
(72) Inventeur: BIARD, Hugo, 38100 GRENOBLE (FR); GAUDIN, Gweltaz, 38920 CROLLES (FR); ROUCHIER, Séverin, 38110 SAINT JEAN DE SOUDAIN (FR); LANDRU, Didier, 38190 CHAMP-PRES-FROGES (FR)
(74) Mandataire: IP Trust
(86) Numéro de dépôt international: PCT/FR2021/050718
(87) Numéro de publication internationale: WO 2021/250333

(56) Documents cités:
- FR-A1- 2 977 069
- US-A1- 2017 278 930

## Description

### DOMAINE DE L'INVENTION

La présente invention concerne le domaine des matériaux semi-conducteurs pour composants microélectroniques. Elle concerne en particulier un substrat temporaire démontable à une température supérieure à 1000°C, voire supérieure à 1200°C, et un procédé de fabrication d'un tel substrat temporaire. L'invention concerne en outre un procédé de transfert d'une couche utile, par exemple en carbure de silicium monocristallin, dudit substrat temporaire vers un substrat receveur.

### ARRIERE PLAN TECHNOLOGIQUE DE L'INVENTION

L'intérêt pour le carbure de silicium (SiC) a considérablement augmenté au cours des dernières années, car ce matériau semi-conducteur peut accroître la capacité de traitement de l'énergie. Le SiC est de plus en plus largement utilisé pour la fabrication de dispositifs de puissance innovants, pour répondre aux besoins de domaines montants de l'électronique, comme notamment les véhicules électriques.

Les dispositifs de puissance et les systèmes intégrés d'alimentation basés sur du carbure de silicium monocristallin peuvent gérer une densité de puissance beaucoup plus élevée par rapport à leurs homologues traditionnels en silicium, et ce avec des dimensions de zone active inférieures. Pour limiter encore les dimensions des dispositifs de puissance sur SiC, il est avantageux de fabriquer des composants verticaux plutôt que latéraux. Pour cela, une conduction électrique verticale, entre une électrode disposée en face avant de la structure SiC et une électrode disposée en face arrière, doit être autorisée par ladite structure.

Les substrats en SiC monocristallin destinés à l'industrie microélectronique restent néanmoins chers et difficiles à approvisionner en grande taille. Il est donc avantageux de recourir à des solutions de transfert de couches minces, pour élaborer des structures composites comprenant typiquement une couche mince en SiC monocristallin sur un substrat support plus bas coût. Une solution de transfert de couche mince bien connue est le procédé Smart Cut^{™}, basé sur une implantation d'ions légers et sur un assemblage par collage direct. Un tel procédé permet par exemple de fabriquer une structure composite comprenant une couche mince en SiC monocristallin (c-SiC), prélevée d'un substrat donneur en c-SiC, en contact direct avec un substrat support en SiC poly-cristallin (p-SiC), et autorisant une conduction électrique verticale.

On connaît par ailleurs le document US8436363, qui décrit un procédé de fabrication d'une structure composite comprenant une couche mince en c-SiC disposée sur un substrat support métallique dont le coefficient de dilatation thermique est apparié avec celui de la couche mince. Ce procédé de fabrication comprend la formation d'un plan fragile enterré dans un substrat donneur de c-SiC, délimitant une couche mince entre ledit plan fragile enterré et une surface avant du substrat donneur. Puis, le dépôt d'une couche métallique, par exemple en tungstène ou en molybdène, est opéré sur la surface avant du substrat donneur pour former le substrat support d'une épaisseur suffisante pour remplir le rôle de raidisseur. Enfin, le procédé comprend la séparation le long du plan fragile enterré, pour former d'une part, la structure composite comprenant le substrat support métallique et la couche mince en c-SiC, et d'autre part, le reste du substrat donneur en c-SiC.

Un tel procédé de fabrication n'est cependant pas compatible lorsque le matériau formant le substrat support est du p-SiC requérant un dépôt à des températures supérieures à 1200°C (températures habituelles pour la fabrication de p-SiC). En effet, à ces températures élevées, la cinétique de croissance des cavités présentes dans le plan fragile enterré est plus rapide que la cinétique de croissance de la couche en p-SiC et l'épaisseur requise pour un effet raidisseur n'est pas atteinte avant l'apparition du phénomène de cloquage, lié à la déformation de la couche à l'aplomb des cavités.

Le document US 2017/278930 A1 décrit un substrat temporaire démontable à une température de démontage supérieure à 1000°C. Le document FR 2 977 069 A1 décrit un substrat temporaire comportant une couche intermédiaire avec une interface de collage.

### OBJET DE L'INVENTION

La présente invention concerne une solution alternative à celles de l'état de la technique, et vise à remédier à tout ou partie des inconvénients précités. Elle concerne en particulier un substrat temporaire démontable à très hautes températures et un procédé de fabrication associé ; elle concerne en outre un procédé de transfert d'une couche utile, pouvant notamment être en carbure de silicium monocristallin, depuis le substrat temporaire vers un substrat receveur, pour former une structure composite.

### BREVE DESCRIPTION DE L'INVENTION

L'invention concerne un substrat temporaire, démontable à une température de démontage supérieure à 1000°C et comprenant :
- une couche utile semi-conductrice s'étendant selon un plan principal,
- un substrat support,
- une couche intermédiaire disposée entre la couche utile et le substrat support, et présentant une épaisseur, selon un axe normal au plan principal, inférieure à 20nm,
- une interface de collage située dans la couche intermédiaire ou adjacente à celle-ci,
- des atomes d'au moins une espèce gazeuse distribués selon un profil de concentration le long de l'axe normal au plan principal, avec un maximum de concentration supérieur à 10²¹/cm³, lesdits atomes restant piégés dans la couche intermédiaire et/ou dans une couche adjacente du substrat support d'épaisseur inférieure ou égale à 10nm et/ou dans une sous-couche adjacente de la couche utile d'épaisseur inférieure ou égale à 10nm, lorsque le substrat temporaire est soumis à une température inférieure à la température de démontage, et lesdits atomes étant destinés à diffuser à une interface de détachement lorsque le substrat temporaire est soumis à une température supérieure ou égale à la température de démontage.

Selon d'autres caractéristiques avantageuses et non limitatives de l'invention, prises seules ou selon toute combinaison techniquement réalisable :
- la couche utile comprend du carbure de silicium, du diamant et/ou du nitrure de gallium ;
- la couche intermédiaire est formée par au moins un matériau choisi parmi le tungstène, le nickel, le titane, l'aluminium, le molybdène, le tantale, le nitrure de titane, le nitrure de tantale, le silicium amorphe ;
- l'espèce gazeuse est l'azote, l'hélium, l'argon, le xénon et/ou l'hydrogène ;
- le substrat support comprend un matériau dont le coefficient de dilatation thermique est égal à ou proche de celui de la couche utile.

L'invention concerne également un procédé de fabrication d'un substrat temporaire tel que ci-dessus, comprenant :
a) une étape de fourniture d'un substrat donneur,
b) une étape d'implantation d'ions légers choisis parmi l'hydrogène, l'hélium ou une combinaison des deux, dans le substrat donneur, pour former un plan fragile enterré dans ledit substrat donneur, le plan fragile enterré délimitant une couche utile superficielle avec une face avant du substrat donneur,
c) une étape de fourniture d'un substrat support présentant une face avant,
d) une étape de dépôt d'au moins un film sur la face avant du substrat donneur et/ou sur la face avant du substrat support, le
   - au moins un- film étant destiné à former la couche intermédiaire,
e) l'assemblage du substrat donneur et du substrat support de sorte que le -au moins un- film soit disposé entre lesdits substrats pour former la couche intermédiaire,
f) la séparation le long du plan fragile enterré, pour former d'une part le substrat temporaire, et d'autre part le reste du substrat donneur.

Le procédé de fabrication comprend en outre une étape d'introduction d'atomes de la -au moins une- espèce gazeuse :
- dans le substrat donneur et/ou dans le substrat support, à une profondeur inférieure ou égale à 10nm en partant de leurs faces avant respectives, avant l'étape d) de dépôt, ou
- dans le -au moins un- film, après l'étape d) de dépôt, ou
- dans la couche intermédiaire, après l'étape f) de séparation.

Selon d'autres caractéristiques avantageuses et non limitatives de l'invention, prises seules ou selon toute combinaison techniquement réalisable :
- l'étape a) de fourniture du substrat donneur comprend une croissance par épitaxie d'une couche donneuse sur un substrat initial, pour former le substrat donneur ;
- le substrat initial et la couche donneuse sont en carbure de silicium, et l'étape a) comprend la formation, sur le substrat initial, d'une couche monocristalline de conversion, pour convertir des défauts de type dislocation du plan basal du substrat initial en défauts de type dislocations coin traversantes, préalablement à la croissance par épitaxie de la couche donneuse ;
- la croissance par épitaxie est effectuée à une température supérieure à 1200°C, préférentiellement comprise entre 1500°C et 1650°C ;
- l'étape f) comprend un traitement thermique à une température comprise entre 900°C et 1200°C.

Enfin, l'invention concerne un procédé de transfert d'une couche utile d'un substrat temporaire tel que précité, sur un substrat receveur. Le procédé comprend :
g) une étape de formation d'une structure démontable comprenant un substrat receveur disposé sur la couche utile du substrat temporaire, l'étape de formation impliquant un traitement à une première température supérieure ou égale à 1000°C,
h) une étape de détachement de la structure démontable le long d'une interface de détachement dans ou adjacente à la couche intermédiaire, l'étape de détachement comprenant un traitement thermique à une température de démontage supérieure à la première température, pour former d'une part une structure composite comprenant la couche utile disposée sur le substrat receveur, et d'autre part le substrat support.

Selon d'autres caractéristiques avantageuses et non limitatives de l'invention, prises seules ou selon toute combinaison techniquement réalisable :
- l'étape g) comprend le dépôt du substrat receveur sur une face libre de la couche utile du substrat temporaire ;
- le dépôt du substrat receveur est opéré par dépôt chimique en phase vapeur, thermique ou assisté, ou par évaporation, à une température supérieure ou égale à 1000°C, préférentiellement supérieure ou égale à 1200°C ;
- le substrat receveur formé est en carbure de silicium poly-cristallin ;
- le substrat receveur est un substrat massif et l'étape g) comprend un assemblage dudit substrat receveur sur la face libre de la couche utile du substrat temporaire ;
- l'assemblage comprend un collage direct par adhésion moléculaire et un traitement thermique à une température supérieure ou égale à 1000°C, voire supérieure ou égale à 1200°C ;
- l'étape h) comprend un traitement thermique à une température supérieure ou égale à 1400°C, voire supérieure ou égale à 1500°C ;
- le procédé de transfert comprend une étape i) de finition de la structure composite, incluant un nettoyage chimique et/ou une gravure chimique et/ou un polissage mécano-chimique de la face libre de la couche utile, face avant de la structure composite ;
- l'étape i) comprend un nettoyage chimique et/ou une gravure chimique et/ou un rodage mécanique et/ou un polissage mécano-chimique de la face libre du substrat receveur, face arrière de la structure composite ;
- le procédé de transfert comprend une étape g') de traitement de la structure démontable, préalable à l'étape h) de détachement, incluant un nettoyage chimique et/ou une gravure chimique et/ou un rodage mécanique et/ou un polissage mécano-chimique de la face arrière du substrat receveur ;
- le procédé de transfert comprend une étape j) de reconditionnement du substrat support, en vue d'une réutilisation en tant que substrat support pour un nouveau substrat temporaire ;
- le procédé de transfert comprend la fabrication de composants électroniques dans ou sur la couche utile de la structure composite, éventuellement après la croissance par épitaxie d'une couche supplémentaire sur la couche utile.

### BREVE DESCRIPTION DES FIGURES

D'autres caractéristiques et avantages de l'invention ressortiront de la description détaillée de l'invention qui va suivre en référence aux figures annexées sur lesquelles :
- Les figures 1a et 1b présentent un substrat temporaire démontable conforme à la présente invention, la figure 1b présentant un zoom de la couche intermédiaire dudit substrat ;
- Les figures 2a à 2f présentent un procédé de fabrication du substrat temporaire démontable, conforme à la présente invention ;
- Les figures 3a et 3b présentent des modes de réalisation particuliers de l'étape a) du procédé de fabrication conforme à l'invention.
- Les figures 4c', 4d, 4e et 4f présentent des étapes du procédé de fabrication du substrat temporaire démontable, selon un premier mode de mise en oeuvre ;
- La figure 5d' présente une étape du procédé de fabrication du substrat temporaire démontable, selon un deuxième mode de mise en oeuvre de l'invention ;
- La figure 6f' présente une étape du procédé de fabrication du substrat temporaire démontable, selon un troisième mode de mise en oeuvre de l'invention ;
- Les figures 7g à 7j présentent des étapes d'un procédé de transfert conforme à l'invention.

### DESCRIPTION DETAILLEE DE L'INVENTION

Dans la partie descriptive, les mêmes références sur les figures pourront être utilisées pour des éléments de même type. Les figures sont des représentations schématiques qui, dans un objectif de lisibilité, ne sont pas à l'échelle. En particulier, les épaisseurs des couches selon l'axe z ne sont pas à l'échelle par rapport aux dimensions latérales selon les axes x et y ; et les épaisseurs relatives des couches entre elles ne sont pas nécessairement respectées sur les figures.

La présente invention concerne un substrat temporaire 10, démontable à une température de démontage supérieure à 1000°C, voire préférentiellement supérieure à 1200°C, supérieure à 1300°C, supérieure à 1400°C, ou supérieure à 1500°C. Par démontable, on entend que le substrat temporaire 10 est apte à se séparer en deux parties, à très hautes températures : en l'occurrence, il permet le transfert d'une couche utile 1 sur un substrat receveur final par détachement entre ladite couche utile 1 et un substrat support 3, tous deux parties du substrat temporaire 10.

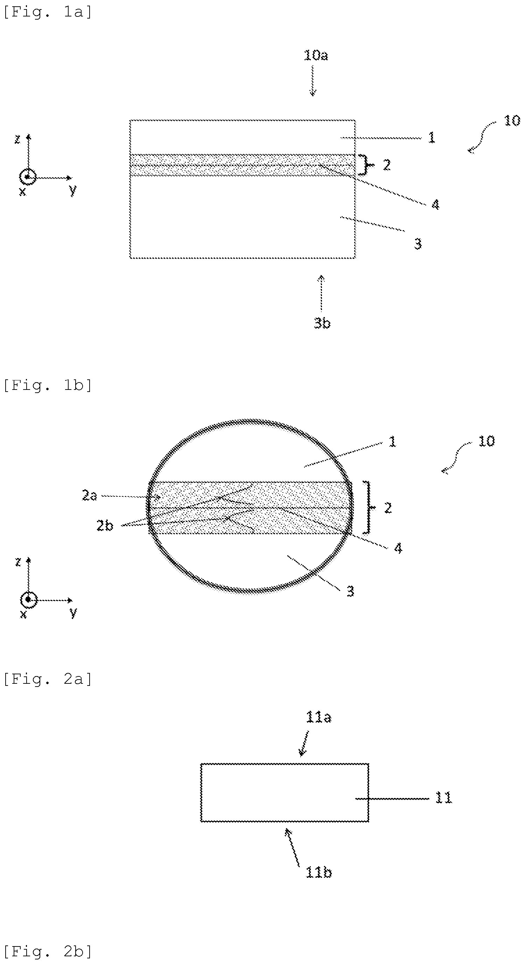

Le substrat temporaire 10 se présente préférentiellement sous la forme d'une plaquette de diamètre 100mm, 150mm, 200mm, voire potentiellement 450mm, et d'épaisseur comprise typiquement entre 300 et 800 microns. Il présente une face avant 10a et une face arrière 3b, s'étendant selon un plan principal (x,y), comme illustré sur les figures 1a et 1b.

Le substrat temporaire 10 comprend une couche utile 1 semi-conductrice disposée sur une couche intermédiaire 2, elle-même disposée sur un substrat support 3. Il comprend également une interface de collage 4, soit située dans la couche intermédiaire 2, soit adjacente à celle-ci, à savoir située entre la couche intermédiaire 2 et la couche utile 1 ou entre la couche intermédiaire 2 et le substrat support 3.

La couche utile 1, en un matériau semi-conducteur, est la couche dans ou sur laquelle des composants sont destinés à être élaborés, pour répondre à une application donnée. Comme le substrat temporaire 10 est particulièrement adapté aux matériaux semi-conducteurs requérant de très hautes températures de traitement, la couche utile 1 comprend avantageusement du carbure de silicium. Bien-sûr, elle pourra également comprendre un ou plusieurs matériaux choisis parmi le diamant, des composés III-V binaires ou ternaires nécessitant des températures d'élaboration élevées, tel que par exemple le nitrure de gallium ou le nitrure d'aluminium, ou des composés II-VI nécessitant également des températures d'élaboration ou de traitement élevées (typiquement supérieures à 1000°C, ou à 1200°C).

La couche utile 1 est disposée sur la couche intermédiaire 2, elle-même incluse dans le substrat temporaire 10. Cette dernière présente une épaisseur, selon un axe z normal au plan principal (x,y), inférieure à 20nm, voire inférieure à 10nm. Cette faible épaisseur est importante en ce qu'elle permet au substrat temporaire 10 de conserver une bonne tenue mécanique et une bonne compatibilité avec des températures très élevées, même si le (ou les) matériau (x) constitutif (s) de la couche intermédiaire 2 présente(nt) une température de fluage ou de fusion inférieure à la température de démontage.

Notons que la couche intermédiaire 2 peut s'étendre continûment parallèlement au plan principal (x,y) ou de manière discontinue, par exemple sous forme de nodules disposés côte-à-côte dans un plan parallèle au plan principal (x,y).

La couche intermédiaire 2 peut être formée par au moins un matériau métallique ou semi-conducteur, par exemple choisi parmi le tungstène, le nickel, le titane, l'aluminium, le molybdène, le tantale, le nitrure de titane, le nitrure de tantale et le silicium amorphe.

Le matériau de la couche intermédiaire 2 est choisi de sorte qu'il ne diffuse pas dans la couche utile 1 et/ou qu'il ne réagisse pas ou peu, à savoir sur une épaisseur très faible de la couche utile 1 (moins de 10nm), aux très hautes températures qui seront appliquées au cours du procédé de transfert mettant en oeuvre le substrat temporaire 10. Cela permet de conserver l'intégrité et la pureté de la couche utile 1.

La couche intermédiaire 2 est disposée sur le substrat support 3, faisant également partie du substrat temporaire 10. Le substrat support 3 peut être formé en tout matériau compatible avec les hautes températures requises ou visées pour le traitement de la couche utile 1. Préférentiellement, le substrat support 3 comprend un matériau dont le coefficient de dilatation thermique est égal ou proche de celui de la couche utile 1. Il pourra par exemple être choisi de même nature que la couche utile 1, mais présenter une moindre qualité cristalline.

Dans le cas particulier d'une couche utile 1 en carbure de silicium, par exemple, le substrat support 3 peut être lui-même formé en carbure de silicium monocristallin, de moindre qualité cristalline que la couche utile 1, ou poly-cristallin.

Le substrat temporaire 10 comprend en outre des atomes 2a d'au moins une espèce gazeuse distribués selon un profil de concentration 2b le long de l'axe z, avec un maximum de concentration supérieur à 10²¹/cm³.

Comme cela sera détaillé plus loin dans le procédé de fabrication du substrat temporaire 10, ces atomes 2a peuvent être introduits à différents moments du procédé et à différents endroits dans les substrats et couches impliqués.

Le profil de concentration 2b des atomes 2a pourra donc présenter différentes formes ; un exemple est illustré sur la figure 1b et dans lequel les atomes 2a sont localisés majoritairement dans la couche intermédiaire 2. Les atomes 2a peuvent alternativement être majoritairement localisés dans une couche du substrat support 3, adjacente à la couche intermédiaire 2 et dont l'épaisseur est inférieure ou égale à 10nm : en d'autres termes, les atomes 2a sont alors majoritairement dans le substrat support 3 mais très proches de la couche intermédiaire 2. Encore alternativement, les atomes 2a peuvent être majoritairement localisés dans une sous-couche de la couche utile 1, adjacente à la couche intermédiaire 2 et dont l'épaisseur est inférieure ou égale à 10nm.

Quelle que soit la localisation des atomes 2a, il est nécessaire que le profil de concentration 2b comporte une région, où la concentration en atomes 2a est maximale et atteint une valeur supérieure ou égale à 10²¹/cm³, voire supérieure ou égale à quelques 10²¹/cm³, typiquement 2^{E}21/cm³ à 5^{E}21/cm³.

Selon l'invention, les atomes 2a restent piégés dans la couche intermédiaire 2 et/ou dans la couche adjacente du substrat support 3 d'épaisseur inférieure ou égale à 10nm et/ou dans la sous-couche adjacente de la couche utile 1 d'épaisseur inférieure ou égale à 10nm, lorsque le substrat temporaire 10 est soumis à une température inférieure à la température de démontage. Ces atomes 2a sont destinés à diffuser à une interface de détachement confondue ou proche de l'interface de collage 4, dans la couche intermédiaire 2 ou adjacente à celle-ci, lorsque le substrat temporaire 10 est soumis à une température supérieure ou égale à la température de démontage.

Le matériau de la couche intermédiaire 2 et l'espèce gazeuse sont choisis de sorte que :
- les atomes restent majoritairement piégés dans la couche intermédiaire 2, du fait de la solubilité élevée de ladite espèce gazeuse dans la couche intermédiaire 2, lorsque le substrat temporaire 10 est soumis à une température inférieure à la température de démontage, ou
- qu'ils restent majoritairement piégés dans la couche fine adjacente du substrat support 3 et/ou dans la sous-couche fine adjacente de la couche utile 1, car la couche intermédiaire 2 forme une barrière efficace pour lesdites espèces, lorsque le substrat temporaire 10 est soumis à une température inférieure à la température de démontage.

Les atomes 2a piégés vont donc majoritairement s'accumuler à l'interface de détachement à partir d'une température critique (la température de démontage) et provoquer le détachement le long de ladite interface, comme cela sera décrit plus loin, dans le procédé de transfert utilisant le substrat temporaire 10.

L'espèce gazeuse est préférentiellement choisie parmi l'azote, l'hélium, l'argon, le xénon et/ou l'hydrogène.

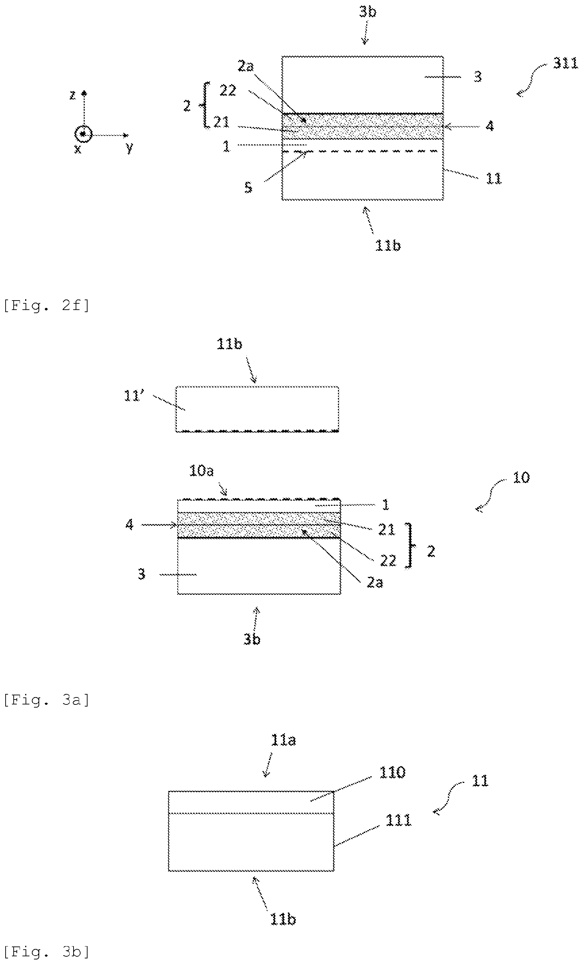

Un procédé de fabrication de la structure temporaire 10 va maintenant être décrit en référence aux figures 2a à 2g et 3a et 3b.

Le procédé de fabrication comprend en premier lieu une étape a) de fourniture d'un substrat donneur 11 présentant une face avant 11a et une face arrière 11b (figure 2a). Le substrat donneur 11 donnera lieu à la couche utile 1 du substrat temporaire 10, il comprend donc au moins le matériau formant la couche utile 1. La rugosité de surface de la face avant 11a du substrat donneur 11 est avantageusement inférieure à 1 nm Ra, rugosité moyenne (« average roughness » selon la terminologie anglo-saxonne) mesurée par microscopie à force atomique (AFM) sur un scan de 20 microns x 20 microns.

Selon une première option, le substrat donneur 11 est un substrat massif, approvisionné avec le niveau de qualité attendu pour la couche utile 1, et cette dernière sera directement issue du substrat donneur 11.

Selon une deuxième option, l'étape a) comprend une croissance par épitaxie d'une couche donneuse 110 sur un substrat initial 111, pour former le substrat donneur 11. La couche donneuse 110 présente préférentiellement une densité de défauts cristallins inférieure à celle du substrat initial 111 (figure 3a).

Dans le cas particulier où le substrat initial 111 et la couche donneuse 110 sont en carbure de silicium, l'étape a) peut comprendre la formation, sur le substrat initial 111, d'une couche monocristalline de conversion 112, pour convertir des défauts de type dislocation du plan basal du substrat initial 111 en défauts de type dislocations coin traversantes, préalablement à la croissance par épitaxie de la couche donneuse 110 (figure 3b). On visera par exemple une densité de défauts de type BPD inférieure ou égale à 1/cm² dans la couche donneuse 110.

La croissance par épitaxie du carbure de silicium est effectuée à une température supérieure à 1200°C, préférentiellement comprise entre 1500°C et 1650°C. Les précurseurs utilisés sont le monosilane (SiH4), le propane (C3H8) ou l'éthylène (C2H4) ; le gaz porteur pourra être de l'hydrogène avec ou sans argon.

Notons que des séquences conventionnelles de nettoyage et/ou de gravure du substrat initial 111, visant à éliminer tout ou partie de contaminants particulaires, métalliques, organiques, ou une couche d'oxyde natif, potentiellement présents sur sa face avant, pourront être réalisées préalablement à la croissance par épitaxie de la couche donneuse 110 (et/ou de la couche de conversion 112).

Le procédé de fabrication comprend ensuite une étape b) d'implantation d'ions légers choisis parmi l'hydrogène, l'hélium ou une combinaison des deux espèces, dans le substrat donneur 11 (et en particulier dans la couche donneuse 110, lorsque celle-ci est présente), pour former un plan fragile enterré 5 dans ledit substrat donneur 11 (figure 2b). Le plan fragile enterré 5 délimite avec la face avant 11a du substrat donneur 11, une couche utile 1 superficielle.

Comme cela est bien connu en référence au procédé Smart Cut^{™}, ces espèces légères vont former, autour de la profondeur d'implantation, des microcavités distribuées dans une fine couche parallèle à la face avant 11a du substrat donneur 11, soit parallèle au plan (x,y) sur les figures. On appelle cette fine couche le plan fragile enterré 5, par souci de simplification.

L'énergie d'implantation des espèces légères est choisie de manière à atteindre une profondeur déterminée dans le substrat donneur 11, laquelle profondeur est adaptée à l'épaisseur visée de la couche utile 1. Par exemple, des ions hydrogène seront implantés à une énergie comprise entre 10 keV et 250 keV, et à une dose comprise entre 5^{E}16/cm2 et 1^{E}17/cm2, pour délimiter une couche utile 1 présentant une épaisseur de l'ordre de 100 à 1500 nm.

Notons qu'une couche de protection peut être déposée sur la face avant 11a du substrat donneur 11, préalablement à l'étape d'implantation ionique des espèces légères. Cette couche de protection peut être composée par un matériau tel que l'oxyde de silicium ou le nitrure de silicium par exemple.

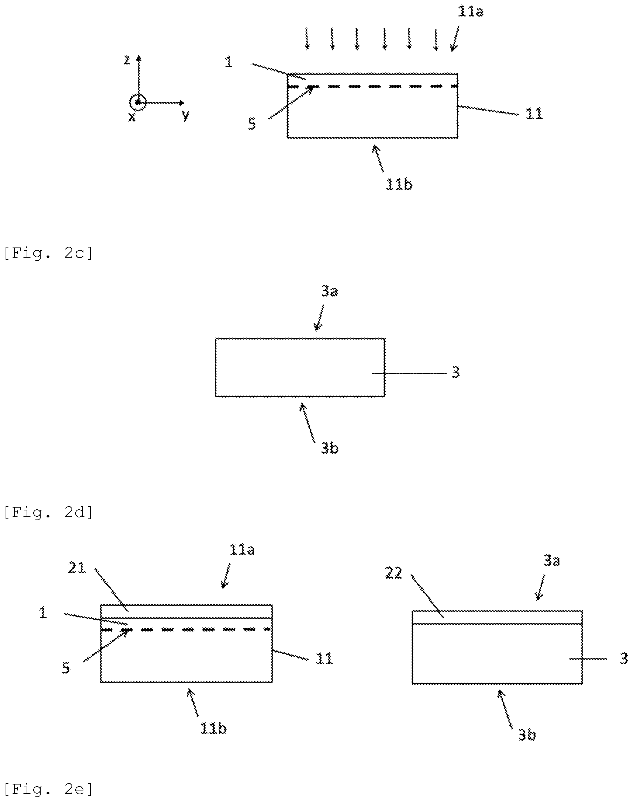

Ensuite, le procédé de fabrication du substrat temporaire 10 comprend une étape c) consistant en la fourniture d'un substrat support 3 (figure 2c).

Comme énoncé précédemment, le substrat support 3 fait office dans le substrat temporaire 10 de support mécanique et n'est pas destiné à être conservé dans la structure composite 51 finale adaptée à une application donnée. Ainsi, les propriétés principales du substrat support 3 sont préférentiellement son bas coût et sa fiabilité en tant que support mécanique de la couche utile 1.

Le procédé de fabrication comprend ensuite une étape d) de dépôt d'au moins un film 21,22 sur le substrat donneur 11 et/ou sur le substrat support 3 (figure 2d). En d'autres termes, un premier film 21 peut être déposé sur la face avant 11a du substrat donneur 11 ; alternativement ou conjointement, un deuxième film 22 peut être déposé sur la face avant 3a du substrat support 3. Dans l'exemple illustré sur la figure 2d, un premier 21 et un deuxième 22 films sont déposés respectivement sur le substrat donneur 11 et le substrat support 3.

Notons que le -au moins un- film 21,22 déposé est destiné à former la couche intermédiaire 2 du substrat temporaire 10.

Le -au moins un- film 21,22 déposé présente une épaisseur, selon un axe z normal au plan principal (x,y), inférieure à 20nm, voire inférieure à 10nm, par exemple comprise entre 0,3nm et 10nm.

A titre d'exemple, le -au moins un- film 21,22 peut être formé par au moins un matériau choisi parmi le tungstène, le nickel, le titane, l'aluminium, le molybdène, le tantale, le nitrure de titane, le nitrure de tantale, le silicium amorphe.

Le dépôt de l'étape d) peut être effectué par toute technique connue, telle que notamment un dépôt chimique en phase vapeur (CVD) thermique, assisté par plasma, assisté par injection liquide directe, un dépôt par pulvérisation ou par évaporation.

Le procédé de fabrication comprend ensuite une étape e) d'assemblage du substrat donneur 11 et du substrat support 3, de sorte que le -au moins un- film 21,22 soit disposé entre lesdits substrats 11,3 et forme la couche intermédiaire 2 (figure 2e).

L'assemblage du substrat donneur 11 et du substrat support 3 s'opère au niveau de leurs faces avant respectives 11a,3a et forme un empilement 311. Comme cela est bien connu en soi, l'assemblage des deux substrats peut être réalisé par collage direct par adhésion moléculaire, c'est-à-dire dans le cas présent par mise en contact direct des faces avant des substrats 11,3, l'une et/ou l'autre des faces étant pourvue d'un film 21,22. Le collage peut être effectué à température ambiante ou à une température inférieure à 800°C, sous atmosphère ambiante ou contrôlée, par exemple sous vide.

L'étape e) peut comprendre, préalablement à cette mise en contact, des séquences classiques de nettoyages, d'activation de surface ou autres préparations de surface, susceptibles de favoriser la qualité de l'interface de collage 4 (faible défectivité, bonne qualité d'adhésion).

L'interface d'assemblage ou de collage 4 se trouve alors dans la couche intermédiaire 2, ou entre cette dernière et la couche utile 1, ou encore entre la couche intermédiaire 2 et le substrat support 3.

Ensuite, le procédé de fabrication comporte une étape f) comprenant la séparation le long du plan fragile enterré 5, pour former d'une part le substrat temporaire 10, et d'autre part le reste du substrat donneur 11' (figure 2f). La face avant 10a du substrat temporaire 10 est également la face avant de la couche utile 1 issue du substrat donneur 11.

Selon un mode avantageux de mise en oeuvre, l'étape f) de séparation est opérée en appliquant un traitement thermique à l'empilement 311, à une température de séparation. Les microcavités présentes dans le plan fragile enterré 5 suivent une cinétique de croissance jusqu'à l'initiation d'une onde de fracture qui va se propager sur toute l'étendue du plan fragile enterré 5 et provoquer la séparation entre le substrat temporaire 10, et le reste du substrat donneur 11'. En pratique, pour un substrat donneur 11 en carbure de silicium, la température pourra être comprise entre 900°C et 1200°C, en fonction des conditions d'implantation de l'étape b).

Selon un mode alternatif de mise en oeuvre, l'étape f) de séparation est opérée par application d'une contrainte mécanique à l'empilement 311, après tout ou partie d'un traitement thermique à une température comprise entre 900°C et 1200°C. La contrainte pourra par exemple être exercée par l'insertion d'un outil (ex : lame de rasoir) à proximité du plan fragile enterré 5. A titre d'exemple, la contrainte de séparation pourra être de l'ordre de quelques GPa, préférentiellement supérieure à 2GPa.

Comme cela est connu en soi, à l'issue de la séparation de l'étape f), la face avant 10a de la couche utile 1 du substrat temporaire 10 présente une rugosité de surface comprise entre 5 et 100 nm RMS (par mesure au microscope à force atomique (AFM), sur des scans de 20 microns x 20 microns).

A la suite de la séparation, l'étape f) peut optionnellement comprendre des traitements de lissage et de guérison de la couche utile 1. On peut citer notamment des traitements thermiques sous atmosphère contrôlée (oxydante ou réductrice), des gravures chimiques humides ou sèches pour retirer une portion superficielle endommagée de la couche utile 1, et/ou des polissages mécano-chimiques de la face avant de la couche utile 1 pour restaurer le bon niveau de rugosité (par exemple, une rugosité finale inférieure à 0,5 nm Rms sur un champ AFM de 20x20pm, voire inférieure à 0,3 nm) et retirer potentiellement une portion superficielle endommagée. Des séquences classiques de nettoyage pourront également être appliquées au substrat temporaire 10, par exemple un nettoyage de type SC1/SC2 (Standard Clean 1, Standard Clean 2) et/ou HF (acide fluorhydrique), ou un plasma N2, Ar, CF4, etc, pour améliorer encore la qualité de la face avant 10a de la couche utile 1.

Le substrat support 3 étant choisi apparié à la couche utile 1, stable mécaniquement et à hautes températures, et la couche intermédiaire 2 étant choisie de très faible épaisseur, les traitements thermiques, mécaniques ou chimiques requis pour restaurer une haute qualité à la couche utile 1 peuvent être aisément appliqués au substrat temporaire 10, sans contrainte ni risque d'endommagement non souhaité de la couche utile 1.

Il est à noter que l'étape f) pourra être suivie d'une étape de croissance par épitaxie d'une couche additionnelle sur la couche utile 1 du substrat temporaire 10. Une telle étape est appliquée lorsqu'une épaisseur relativement importante de couche utile est nécessaire, typiquement de l'ordre de quelques microns à quelques dizaines de microns, par exemple de 5 microns à 50 microns. La température d'épitaxie est avantageusement choisie inférieure à 1500°C, voire inférieure à 1300°C, pour éviter d'initier prématurément le démontage du substrat temporaire 10.

Au cours ou à l'issue de l'étape f), qui implique préférentiellement un traitement thermique à hautes températures, la couche intermédiaire 2 peut subir des modifications physiques et/ou morphologiques. Le -au moins unfilm 21,22 peut éventuellement former des nodules intercalés avec des régions jointives entre le matériau de la couche utile 1 et le matériau du substrat support 3 : la couche intermédiaire 2 est alors formée d'une couche discontinue de nodules. L'interface d'assemblage 4 est donc elle aussi sensiblement modifiée : elle peut se trouver dans les nodules, entre les nodules et la couche utile 1, entre les nodules et le substrat support 3, et/ou entre la couche utile 1 et le substrat support 3. Alternativement, la couche intermédiaire 2 peut conserver sa forme continue tout le long de l'interface d'assemblage 4.

Le procédé de fabrication comprend en outre une étape d'introduction d'atomes 2a d'au moins une espèce gazeuse dans le -au moins un- film 21,22, ou à proximité de celui-ci. Comme évoqué précédemment dans la description du substrat temporaire 10, l'espèce gazeuse pourra être de l'azote, de l'hélium, de l'argon, du xénon et/ou de l'hydrogène. Les atomes 2a de cette espèce gazeuse sont ceux destinés à être piégés dans la couche intermédiaire 2, et/ou dans une couche adjacente du substrat support 3 d'épaisseur inférieure ou égale à 10nm et/ou dans une sous-couche adjacente de la couche utile 1 d'épaisseur inférieure ou égale à 10nm.

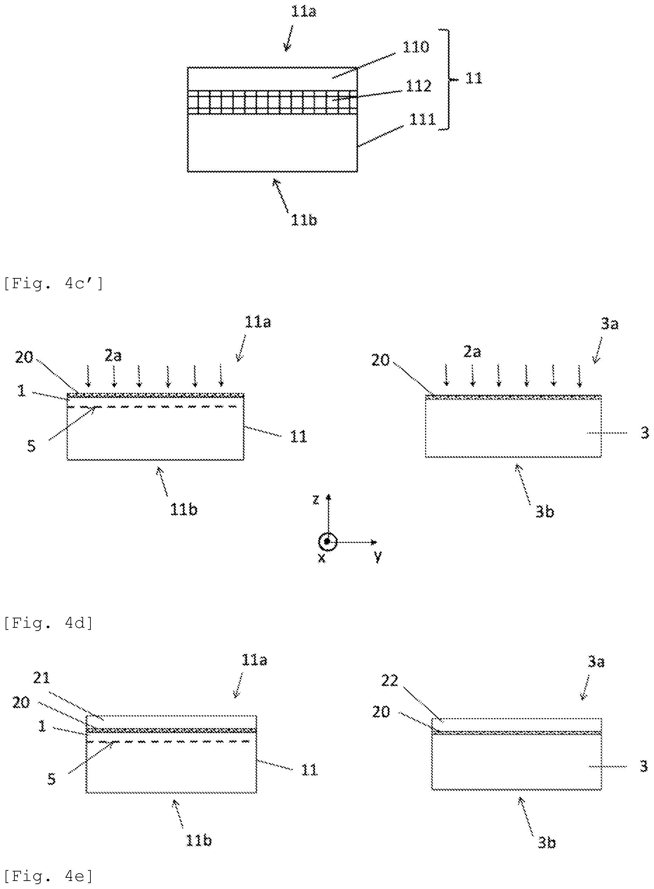

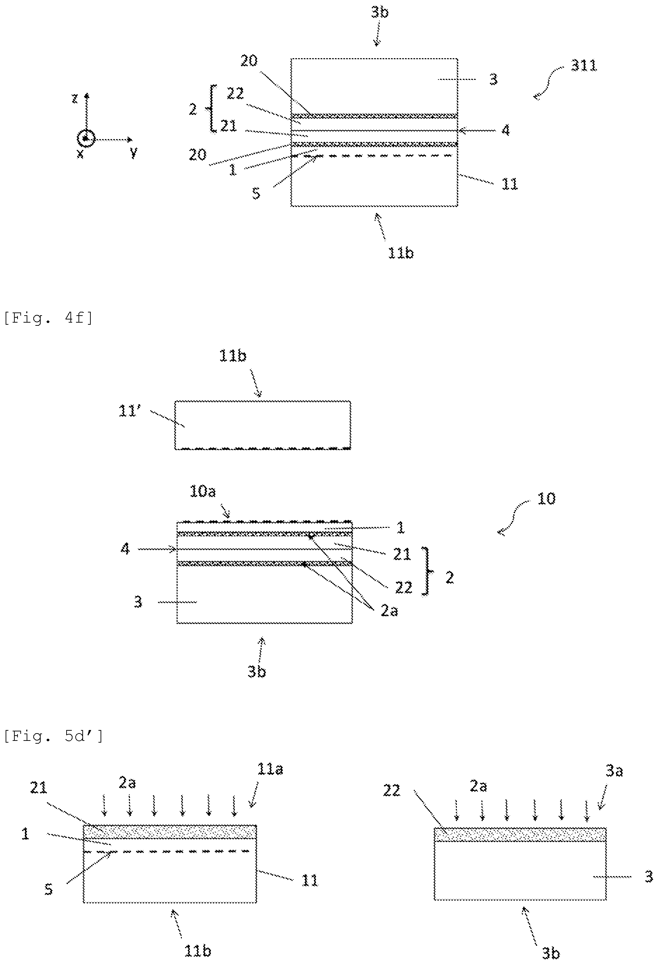

Dans un premier mode de mise en oeuvre, illustré sur les figures 4c', 4d, 4e et 4f, nous nommerons c') cette étape d'introduction d'atomes 2a car elle est opérée préalablement à l'étape d) de dépôt du film 21,22. Les atomes 2a sont introduits dans le substrat donneur 11 et/ou dans le substrat support 3, à une faible profondeur, inférieure à 10nm en partant de leurs faces avant 11a,3a respectives. Une implantation ionique peut être opérée pour introduire les atomes 2a sous forme d'ions dans le ou les substrat(s) 11,3, avec une énergie d'implantation des ions typiquement inférieure à 10keV, voire inférieure à 5keV et une dose d'implantation typiquement comprise entre 2^{E}15/cm² et quelques 1^{E}16/cm². Une zone implantée 20 est ainsi formée proche de la surface de la face avant 11a du substrat donneur 11, et/ou proche de la surface de la face avant 3a du substrat support 3. Les étapes d) à f) du procédé sont ensuite opérées comme précédemment décrit et sont illustrées sur les figures 4d, 4e, 4f.

Les atomes 2a sont localisés dans une couche fine (épaisseur inférieure ou égale à 10nm) du substrat support 3, adjacente à la couche intermédiaire 2, et une sous-couche fine (épaisseur inférieure ou égale à 10nm) de la couche utile 1, adjacente à la couche intermédiaire 2 ; lesdites couche et sous-couche adjacentes sont issues des zones implantées 20. Selon la nature des espèces gazeuses et de la couche intermédiaire 2, les atomes 2a pourront rester piégés dans les couche et sous-couche précitées ou venir se piéger dans la couche intermédiaire 2, au cours de traitements thermiques appliqués au substrat temporaire 10, tant que ce dernier n'est pas soumis à une température supérieure ou égale à la température de démontage, laquelle est nettement plus élevée que la température de séparation de l'étape f) .

Les atomes 2a de l'espèce gazeuse sont distribués selon un profil de concentration le long de l'axe z normal au plan principal (x,y), avec un maximum de concentration supérieur à 10²¹/cm³.

Dans un deuxième mode de mise en oeuvre, illustré sur la figure 5d', nous nommerons d') l'étape d'introduction d'atomes 2a car elle est opérée après l'étape d) de dépôt du film 21,22.

Comme déjà évoqué, le -au moins un- film 21,22 peut être présent sur le substrat donneur 11 et/ou sur le substrat support 3.

Les atomes 2a sont introduits dans au moins un film 21,22. Une implantation ionique peut être opérée pour introduire les atomes 2a sous forme d'ions avec une énergie d'implantation des ions typiquement inférieure à 10keV, voire inférieure à 5keV, et dépendante de l'épaisseur du film 21,22 déposé à l'étape d). La dose d'implantation est typiquement comprise entre 2^{E}15/cm² et quelques 1^{E}16/cm².

Dans la couche intermédiaire 2, les atomes 2a de l'espèce gazeuse sont distribués selon un profil de concentration le long de l'axe z, avec un maximum de concentration, situé au niveau du pic d'implantation, supérieur à 10²¹/cm³.

Les étapes e) à f) du procédé sont ensuite opérées comme précédemment décrit (figures 2e, 2f).

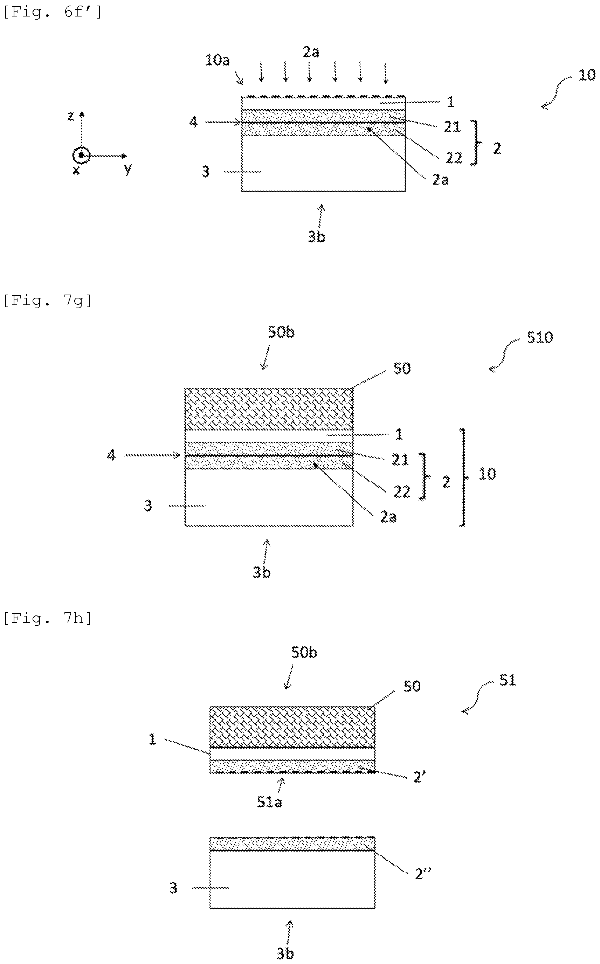

Dans un troisième mode de mise en oeuvre, illustré sur la figure 6f', nous nommerons f') l'étape d'introduction d'atomes 2a car elle est opérée après l'étape f) de séparation.

Les atomes 2a sont introduits dans la couche intermédiaire 2, par exemple par implantation ionique. L'énergie d'implantation des ions dépend, dans ce cas, de la nature et de l'épaisseur de la couche utile 1, que les ions vont traverser pour atteindre la couche intermédiaire 2. La dose d'implantation est typiquement comprise entre 2^{E}15/cm² et quelques 1^{E}16/cm².

Les atomes 2a de l'espèce gazeuse sont ici encore distribués selon un profil de concentration le long de l'axe z, avec un maximum de concentration situé au niveau du pic d'implantation et attendu supérieur à 10²¹/cm³.

Dans l'un ou l'autre des trois modes de mise en oeuvre décrits, la dose totale d'ions implantés est définie de sorte que le profil de concentration des atomes 2a présente un maximum de concentration supérieur à 10²¹/cm³, dans le substrat temporaire 10 finalisé.

L'introduction de doses importantes d'atomes 2a de l'espèce gazeuse dans et/ou très proche de la couche intermédiaire 2 va permettre de générer une interface de détachement dans la couche intermédiaire 2 ou adjacente à celle-ci, au cours du procédé de transfert de l'invention, qui est décrit ci-après.

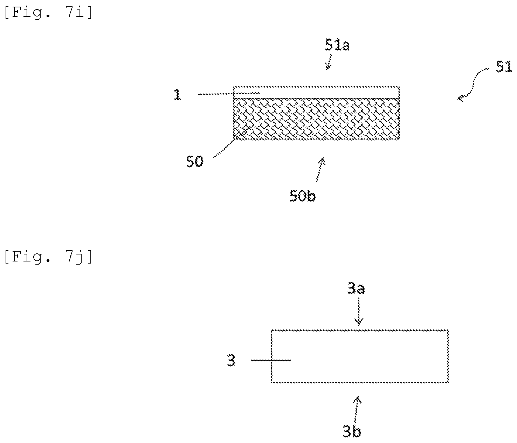

La présente invention concerne également un procédé de transfert de la couche utile 1 d'un substrat temporaire 10 tel que précédemment décrit, sur un substrat receveur 50. Le procédé de transfert est décrit en référence aux figures 7g à 7j.

Le substrat receveur 50 se présente préférentiellement sous la forme d'une plaquette de diamètre 100mm, 150mm, 200mm, voire potentiellement 450mm, et d'épaisseur comprise typiquement entre 300 et 800 microns. Il comporte une face avant et une face arrière 50b, opposées l'une à l'autre. Le substrat receveur 50 est adapté à l'application finale, ses propriétés physiques et électriques sont donc choisies spécialement en fonction des spécifications requises.

Pour une application d'électronique de puissance, pour laquelle la couche utile 1 est par exemple en carbure de silicium de haute qualité cristalline, la substrat receveur 50 pourra notamment être en carbure de silicium poly-cristallin, présentant une bonne conductivité électrique de manière à procurer un chemin de conduction vertical.

Le procédé de transfert comprend une étape g) de formation d'une structure démontable 510 comprenant le substrat receveur 50 disposé sur la couche utile 1 du substrat temporaire 10 (figure 7g). Notons que le substrat temporaire 10 de la figure 7g est illustré avec des atomes 2a de l'espèce gazeuse piégés dans la couche intermédiaire 2 ; toute autre configuration décrite précédemment, avec une localisation différente des atomes 2a, pourrait bien sûr être mise en oeuvre.

L'étape g) implique un traitement à une première température supérieure ou égale à 1000°C, et avantageusement inférieure ou égale à 1500°C.

Selon un premier mode de réalisation, l'étape g) comprend le dépôt du substrat receveur 50 sur la face libre 10a de la couche utile 1 du substrat temporaire 10. Le dépôt peut être effectué à une température (correspondant à la première température) supérieure à 1000°C, supérieure ou égale à 1200°C, voire supérieure à 1400°C, en particulier lorsque l'on souhaite déposer un substrat receveur 50 en carbure de silicium poly-cristallin de bonne qualité, sur une couche utile 1 en carbure de silicium monocristallin de très haute qualité. Bien sûr d'autres matériaux déposés à très hautes températures pourraient être intéressants pour constituer le substrat receveur 50. Pour des applications nécessitant une conduction électrique entre la couche utile 1 et le substrat receveur 50, une interface non-isolante doit être définie entre ceux-ci. En d'autres termes, l'étape g) est réalisée de sorte que l'interface entre la couche utile 1 et le substrat receveur 50 soit électriquement conductrice : on visera une résistance spécifique de l'interface typiquement inférieure à 1 mohm.cm². Avantageusement, pour assurer la conductivité électrique de l'interface, un retrait de l'oxyde natif présent sur la face libre 10a de la couche utile 1 est réalisé par désoxydation HF (acide fluorhydrique), par voie humide ou sèche. Alternativement, un surdopage des premiers nanomètres déposés du substrat receveur 50 peut favoriser la conductivité électrique de l'interface entre la couche utile 1 et ledit substrat 50.

De manière également avantageuse, préalablement à la désoxydation et/ou à la formation du substrat receveur 50, des séquences de nettoyage sont appliquées au substrat temporaire 10 pour éliminer tout ou partie de contaminants particulaires, métalliques ou organiques potentiellement présents sur ses faces libres 10a,3b.

Dans le premier mode de réalisation, on notera que la couche utile 1 du substrat temporaire 10 n'a pas nécessairement besoin de subir un polissage visant à restaurer totalement sa rugosité de surface après la séparation de l'étape f). L'élaboration du substrat receveur 50 par dépôt ou épitaxie à très haute température (typiquement entre 1100°C et 1500°C) peut favoriser la guérison et la reconstruction de la surface de la couche utile 1 et peut en outre tolérer un résidu de rugosité.

Le substrat support 3 étant choisi apparié à la couche utile 1, stable mécaniquement et à hautes températures, et la couche intermédiaire 2 étant choisie de très faible épaisseur, les traitements thermiques, mécaniques ou chimiques requis pour la formation de la structure démontable 510 peuvent être aisément appliqués au substrat temporaire 10, sans contrainte ni risque d'endommagement non souhaité de la couche utile 1.

Dans ce premier mode de réalisation, le dépôt de l'étape g) peut être réalisé par une technique d'évaporation ou de dépôt chimique en phase vapeur (CVD, pour « Chemical vapor deposition »). Des techniques de CVD thermique comme un dépôt à pression atmosphérique (APCVD pour « atmospheric pressure CVD) ou à basse pression (LPCVD pour « low pressure CVD »), ou de CVD assistée par plasma (PECVD pour « plasma enhanced CVD »), ou encore de CVD par injection liquide directe (DLI-CVD), peuvent être utilisées.

Pour obtenir les propriétés de conductivité électrique requises dans les applications de puissance précitées, et en reprenant l'exemple d'un substrat receveur 50 en carbure de silicium, ce dernier peut par exemple présenter les caractéristiques structurelles suivantes : structure poly-cristalline, grains de type 3C SiC, orientés 111, de taille moyenne 1 à 50µm, dopage de type N pour une résistivité finale inférieure ou égale à 0,03 ohm.cm.

A l'issue de l'étape g), le substrat receveur 50 présente une épaisseur typiquement supérieure ou égale à 50 microns, voire une épaisseur supérieure ou égale à 100 microns, par exemple de l'ordre de 300 microns. La structure démontable 510 résultant de l'étape g) comprend le substrat receveur 50 disposé sur la couche utile 1, elle-même incluse dans le substrat temporaire 10. La première température mise en oeuvre pour l'élaboration du substrat receveur 50 est inférieure à la température de démontage, les atomes 2a de l'espèce gazeuse restent donc majoritairement piégés dans la couche intermédiaire 2, et/ou dans une couche adjacente du substrat support 3 d'épaisseur inférieure ou égale à 10nm et/ou dans une sous-couche adjacente de la couche utile 1 d'épaisseur inférieure ou égale à 10nm.

Selon un deuxième mode de réalisation, dans lequel le substrat receveur 50 est un substrat massif, l'étape g) comprend un assemblage dudit substrat receveur 50 sur la face libre 10a de la couche utile 1 du substrat temporaire 10, pour former la structure démontable 510.

L'assemblage peut être réalisé par toute technique connue, notamment par collage direct par adhésion moléculaire, par collage par thermocompression ou autre collage compatible avec de très hautes températures. Pour consolider ce collage, l'étape g) comprend en outre un traitement thermique à une température (correspondant à la première température) supérieure ou égale à 1000°C, voire supérieure ou égale à 1200°C.

Le procédé de transfert selon l'invention comprend ensuite une étape h) de détachement de la structure démontable 510 le long d'une interface de détachement située dans la couche intermédiaire 2 ou adjacente à celle-ci. Cette étape forme d'une part une structure composite 51 comprenant la couche utile 1 disposée sur le substrat receveur 50, et d'autre part le substrat support 3 (figure 7h). L'étape de détachement implique un traitement thermique à une température de démontage supérieure à la température de séparation de l'étape f) et supérieure à la première température appliquée lors de l'étape g). La température de démontage est supérieure à 1000°C.

Typiquement, dans le cas particulier d'une couche intermédiaire 2 comprenant du tungstène implanté avec des atomes 2a d'azote, d'une couche utile 1 et d'un substrat support 3 en SiC, la température de démontage peut être obtenue supérieure ou égale à 1400°C, voire supérieure ou égale à 1500°C, par exemple 1600°C ou 1700°C.

Les atomes 2a présents dans le substrat temporaire 10 migrent au cours du traitement thermique de l'étape h) et viennent s'accumuler au niveau d'une interface de détachement confondue ou proche de l'interface d'assemblage 4, dans la couche intermédiaire 2 ou adjacente à la couche intermédiaire 2. Les espèces gazeuses génèrent alors des microfissures pressurisées qui augmentent en pression et induisent un détachement au coeur de la structure démontable 510 et sur toute sa superficie, parallèlement au plan principal (x,y).

Selon un mode particulier, la couche intermédiaire 2 subit, au cours de l'étape h) ou préalablement lors d'un traitement thermique antérieur, une segmentation sous forme de nodules. Ces derniers sont alors intercalés avec des régions jointives entre le matériau de la couche utile 1 et le matériau du substrat support 3. L'accumulation des espèces gazeuses qui s'opère à l'étape h) se fait alors préférentiellement au niveau desdites régions jointives, induisant des microfissures sous pression.

Le phénomène de détachement dans le procédé de transfert selon l'invention est particulièrement intéressant car il n'apparaît qu'à une température de démontage, supérieure aux températures très élevées appliquées préalablement au substrat temporaire 10 ou à la structure démontable 510, et donne donc accès à plusieurs types d'étapes de formation de ladite structure démontable 510. En particulier des premières températures élevées permettent d'obtenir une très bonne qualité de substrat receveur 50 (dans le premier mode de réalisation) et/ou une très bonne qualité d'assemblage du substrat receveur 50 sur la couche utile 1 (dans le deuxième mode de réalisation), sans induire une évolution prématurée de l'interface de détachement au niveau de la couche intermédiaire 2.

Il est donc possible, dans un deuxième temps, et à la température de démontage plus élevée, de déclencher le détachement de la structure démontable 510 et de former la structure composite 51.

Le procédé de transfert selon l'invention peut ensuite comprendre une étape i) de finition de la structure composite 51, incluant un nettoyage chimique et/ou une gravure chimique et/ou un polissage mécano-chimique de la face libre de la couche utile 1, face avant 51a de la structure composite 51. On notera qu'une gravure chimique ou un polissage peut être utile pour retirer les résidus de couche intermédiaire 2' au niveau de la face avant 51a de la structure composite 51.

L'étape i) peut également comprendre un nettoyage chimique et/ou une gravure chimique et/ou un rodage mécanique et/ou un polissage mécano-chimique appliqué(s) de la face libre 50b du substrat receveur 50, face arrière 50b de la structure composite 51.

On pourra également réaliser lors de cette étape i) un polissage ou une rectification des bords de la structure composite 51 pour rendre compatible la forme de son contour circulaire et de la tombée de bord avec les exigences des procédés de fabrication microélectronique, notamment dans le premier mode de réalisation, pour lequel le substrat receveur 50 est formé par dépôt.

L'étape i) peut enfin comprendre une croissance par épitaxie d'une couche additionnelle sur la couche utile 1 de la structure composite 51. Une telle étape est appliquée lorsque l'épaisseur de la couche utile 1 transférée du substrat temporaire 10 n'est pas suffisante pour la fabrication de composants, ou qu'une couche de dopage ou de composition particulier(ère) est requise en surface de la couche utile 1 pour lesdits composants.

Optionnellement, le procédé de transfert peut comprendre une étape g') de traitement de la structure démontable 510, préalable à l'étape h) de détachement, qui inclut un nettoyage chimique et/ou une gravure chimique et/ou un rodage mécanique et/ou un polissage mécano-chimique de la face arrière 50b du substrat receveur 50 et, potentiellement, une rectification des bords de la structure démontable 510. Cela permet de traiter et affiner la forme et l'épaisseur du substrat receveur 50, sans risque de dégradation de la couche utile 1, encore enterrée dans la structure démontable 510.

Enfin, le procédé de transfert selon l'invention peut comprendre une étape j) de reconditionnement du substrat support 3, en particulier en vue d'une réutilisation en tant que substrat support pour un nouveau substrat temporaire 10 (figure 7j). Une telle étape de reconditionnement est basée sur un ou plusieurs traitements de la face avant du substrat 3 à l'issue de l'étape h), par polissage mécano-chimique de surface ou de bords, et/ou par rectification mécanique, et/ou par gravure chimique sèche ou humide.

### Exemples de mise en oeuvre

Selon un exemple non limitatif de mise en oeuvre, le substrat initial 111 fourni à l'étape a) du procédé de fabrication est une plaquette de c-SiC, de polytype 4H, d'orientation 4.0° par rapport à l'axe <11-20> ±0.5°, de diamètre 150mm et d'épaisseur 350pm. Une séquence classique de nettoyage de type RCA (Standard Clean 1 + Standard Clean 2), puis Caro (mélange d'acide sulfurique et d'eau oxygénée), puis HF (acide fluorhydrique), est opérée sur le substrat initial 111 préalablement à la croissance épitaxiale de la couche donneuse 110 en c-SiC.

La croissance est réalisée dans une chambre d'épitaxie, à une température de 1650°C, avec des précurseurs tels que le monosilane (SiH4) et le propane (C3H8) ou l'éthylène (C2H4), générant la couche donneuse 110 en c-SiC de 30 microns d'épaisseur (vitesse de croissance : 10 microns/h). La couche donneuse 110 présente une densité de défauts BPD de l'ordre de 1/cm².

L'implantation d'ions hydrogène de l'étape b) est opérée à une énergie de 150 keV et une dose de 6^{E}16 H+/cm², à travers la surface libre de la couche donneuse 110. Un plan fragile enterré 5 est ainsi créé à une profondeur d'environ 800 nm dans la couche donneuse 110.

Un substrat support 3 en carbure de silicium monocristallin de faible qualité cristalline, de diamètre 150mm et d'épaisseur 550pm est fourni à l'étape c).

Une séquence de nettoyage de type RCA + Caro est appliquée au substrat donneur 11 et au substrat support 3, de manière à éliminer les potentielles contaminations sur leurs faces libres. Un dépôt de tungstène d'une épaisseur de 0,5nm est opéré (étape d)) sur la face avant 11a du substrat donneur 11 et sur la face avant 3a du substrat support 3, par dépôt chimique en phase vapeur, à une température de l'ordre de 700°C, pour former un premier 21 et un deuxième 22 film.

Une implantation d'azote (étape d') est effectuée dans le film 21 du substrat donneur 11, avec une énergie d'implantation de 5keV et une dose de 1^{E}16/cm2, de manière à placer le pic d'implantation (maximum de concentration) dans le film 21.

L'étape e) prévoit ensuite le collage par adhésion moléculaire du film implanté 21 du substrat donneur 11, sur le film 22 du substrat support 3, le long d'une interface de collage 4, de manière à former l'empilement 311. Les deux films 21,22 forment la couche intermédiaire 2.

L'étape f) de séparation s'opère le long du plan fragile enterré 5, en appliquant un traitement thermique à 950°C pendant plusieurs dizaines de minutes, voire une heure. Le substrat temporaire 10 est ainsi formé, avec sa couche utile 1 superficielle. Le reste du substrat donneur 11' pourra être reconditionné et réutilisé pour un nouveau cycle.

Un polissage mécano-chimique retirant environ 200nm en surface de la couche utile 1 est effectué, ainsi qu'un traitement thermique de guérison de ladite couche utile 1, à une température supérieure ou égale à 1200°C. Au cours de cette étape, les atomes 2a de l'espèce gazeuse restent majoritairement piégés dans la couche intermédiaire 2.

En vue du transfert de la couche utile 1 sur un substrat receveur 50 pour fabriquer la structure composite 51, un dépôt LP-CVD de carbure de silicium poly-cristallin est effectué sur la couche utile 1 du substrat temporaire 10, à une température de 1250°C, avec le précurseur méthylsilane, pendant 120 minutes, de manière à atteindre une épaisseur de 360 microns pour le substrat receveur 50. Dans ces conditions, le substrat receveur 50 est un poly-cristal de très bonne qualité (étape g). Des étapes de rodage (« grinding ») et/ou polissage pourront être effectuées pour ajuster l'épaisseur du substrat receveur 50 et éventuellement la forme de ses bords périphériques. La structure démontable 510 est ainsi créée.

L'étape h) de détachement ou de démontage correspond à un traitement thermique à 1700°C appliqué à la structure démontable 510. Une interface de détachement, induite par la diffusion des atomes 2a d'azote piégés dans la couche intermédiaire 2 et par leur accumulation pour former des microfissures pressurisées au niveau de l'interface de collage 4 ou très proche de cette dernière, se développe dans la couche intermédiaire 2, jusqu'à provoquer le détachement total de la structure démontable 510. On obtient ainsi, d'une part la structure composite 51 comprenant la couche utile 1 disposée sur le substrat receveur 50, et d'autre part, la substrat support 3. La structure composite 51 et le substrat support 3 comporte chacun un résidu 2',2" de la couche intermédiaire 2 qui peut être retiré par exemple par polissage ou par gravure chimique.

Un rodage mécanique ou un polissage mécano-chimique est préférentiellement appliqué à la face arrière de la structure composite 51, s'il n'a pas été réalisé sur la structure démontable 510.

La face avant 51a de ladite structure 51, correspondant à la face libre 51a de la couche utile 1 ne nécessite en principe qu'un nettoyage classique car la qualité de la couche ainsi que sa faible rugosité de surface étaient acquises dans le substrat temporaire 10.

Des composants verticaux peuvent ensuite être élaborés sur la structure composite 51, éventuellement après la croissance par épitaxie d'une couche supplémentaire sur la couche utile 1.

Dans des conditions similaires à celles décrites dans l'exemple ci-dessus, le matériau du -au moins un- film 21,22 pourrait être du silicium amorphe et les atomes 2a introduits de l'argon ou de l'hélium.

Bien entendu, l'invention n'est pas limitée aux modes de réalisation et aux exemples décrits, et on peut y apporter des variantes de réalisation sans sortir du cadre de l'invention tel que défini par les revendications.

## Revendications

1. - Substrat temporaire (10), démontable à une température de démontage supérieure à 1000°C et comprenant :
- une couche utile (1) semi-conductrice s'étendant selon un plan principal (x,y),
- un substrat support (3),
- une couche intermédiaire (2) disposée entre la couche utile (1) et le substrat support (3), et présentant une épaisseur, selon un axe normal (z) au plan principal (x,y), inférieure à 20nm,
- une interface de collage (4) située dans la couche intermédiaire (2) ou adjacente à celle-ci,
- des atomes (2a) d'au moins une espèce gazeuse distribués selon un profil de concentration (2b) le long de l'axe normal (z) au plan principal (x,y), avec un maximum de concentration supérieur à 10²¹/cm³, lesdits atomes (2a) restant piégés dans la couche intermédiaire (2) et/ou dans une couche adjacente du substrat support (3) d'épaisseur inférieure ou égale à 10nm et/ou dans une sous-couche adjacente de la couche utile (1) d'épaisseur inférieure ou égale à 10nm, lorsque le substrat temporaire (10) est soumis à une température inférieure à la température de démontage, et lesdits atomes (2a) étant destinés à diffuser à une interface de détachement lorsque le substrat temporaire (10) est soumis à une température supérieure ou égale à la température de démontage.

2. - Substrat temporaire (10) selon la revendication précédente, dans lequel la couche intermédiaire (2) est formée par au moins un matériau choisi parmi le tungstène, le nickel, le titane, l'aluminium, le molybdène, le tantale, le nitrure de titane, le nitrure de tantale, le silicium amorphe.

3. - Substrat temporaire (10) selon l'une des revendications précédentes, dans lequel l'espèce gazeuse est l'azote, l'hélium, l'argon, le xénon et/ou l'hydrogène.

4. - Substrat temporaire (10) selon l'une des revendications précédentes, dans lequel le substrat support (3) comprend un matériau dont le coefficient de dilatation thermique est égal à ou proche de celui de la couche utile (1).

5. - Procédé de fabrication d'un substrat temporaire (10) conforme à l'une des revendications précédentes, comprenant :
a) une étape de fourniture d'un substrat donneur (11),
b) une étape d'implantation d'ions légers choisis parmi l'hydrogène, l'hélium ou une combinaison des deux, dans le substrat donneur (11), pour former un plan fragile enterré (5) dans ledit substrat donneur (11), le plan fragile enterré (5) délimitant une couche utile (1) superficielle avec une face avant (11a) du substrat donneur (11),
c) une étape de fourniture d'un substrat support (3) présentant une face avant (3a),
d) une étape de dépôt d'au moins un film (21,22) sur la face avant (11a) du substrat donneur (11) et/ou sur la face avant (3a) du substrat support (3), le -au moins un- film étant destiné à former la couche intermédiaire (2),
e) l'assemblage du substrat donneur (11) et du substrat support (3) de sorte que le -au moins un- film (21,22) soit disposé entre lesdits substrats (11,3) pour former la couche intermédiaire (2),
f) la séparation le long du plan fragile enterré (5), pour former d'une part le substrat temporaire (10), et d'autre part le reste du substrat donneur (11'),
le procédé de fabrication comprenant en outre une étape d'introduction d'atomes (2a) de la -au moins une- espèce gazeuse :
- dans le substrat donneur (11) et/ou dans le substrat support (3), à une profondeur inférieure ou égale à 10nm en partant de leurs faces avant (11a,3a) respectives, avant l'étape d) de dépôt, ou
- dans le -au moins un- film (21,22), après l'étape d) de dépôt, ou
- dans la couche intermédiaire (2), après l'étape f) de séparation.

6. - Procédé de fabrication d'un substrat temporaire (10), selon la revendication précédente, dans lequel l'étape f) comprend un traitement thermique à une température comprise entre 900°C et 1200°C.

7. - Procédé de transfert d'une couche utile (1) d'un substrat temporaire (10) conforme à l'une des revendications 1 à 4, sur un substrat receveur (50), le procédé comprenant :
g) une étape de formation d'une structure démontable (510) comprenant un substrat receveur (50) disposé sur la couche utile (1) du substrat temporaire (10), l'étape de formation impliquant un traitement à une première température supérieure ou égale à 1000°C,
h) une étape de détachement de la structure démontable (510) le long d'une interface de détachement dans ou adjacente à la couche intermédiaire (2), l'étape de détachement comprenant un traitement thermique à une température de démontage supérieure à la première température, pour former d'une part une structure composite (51) comprenant la couche utile (1) disposée sur le substrat receveur (50), et d'autre part le substrat support (3).

8. - Procédé de transfert d'une couche utile (1) d'un substrat temporaire (10), selon la revendication précédente, dans lequel l'étape g) comprend le dépôt du substrat receveur (50) sur une face libre de la couche utile (1) du substrat temporaire (10).

9. - Procédé de transfert d'une couche utile (1) d'un substrat temporaire (10), selon la revendication précédente, dans lequel le dépôt du substrat receveur (50) est opéré par dépôt chimique en phase vapeur, thermique ou assisté, ou par évaporation, à une température supérieure ou égale à 1000°C, préférentiellement supérieure ou égale à 1200°C.

10. - Procédé de transfert d'une couche utile (1) d'un substrat temporaire (10), selon l'une des deux revendications précédentes, dans lequel le substrat receveur (50) formé est en carbure de silicium poly-cristallin.

11. - Procédé de transfert d'une couche utile (1) d'un substrat temporaire (10), selon l'une des revendications 7 à 10, dans lequel l'étape h) comprend un traitement thermique à une température supérieure ou égale à 1400°C, voire supérieure ou égale à 1500°C.

12. - Procédé de transfert d'une couche utile (1) d'un substrat temporaire (10), selon l'une des revendications 7 à 11, comprenant une étape i) de finition de la structure composite (51), incluant un nettoyage chimique et/ou une gravure chimique et/ou un polissage mécano-chimique de la face libre de la couche utile (1), face avant (51a) de la structure composite (51).

13. - Procédé de transfert d'une couche utile (1) d'un substrat temporaire (10), selon la revendication précédente, dans lequel l'étape i) comprend un nettoyage chimique et/ou une gravure chimique et/ou un rodage mécanique et/ou un polissage mécano-chimique de la face libre du substrat receveur (50), face arrière (50b) de la structure composite (51) .

14. - Procédé de transfert d'une couche utile (1) d'un substrat temporaire (10), selon l'une des revendications 7 à 13, comprenant une étape g') de traitement de la structure démontable (510), préalable à l'étape h) de détachement, incluant un nettoyage chimique et/ou une gravure chimique et/ou un rodage mécanique et/ou un polissage mécano-chimique de la face arrière (50b) du substrat receveur (50).

15. - Procédé de transfert d'une couche utile (1) d'un substrat temporaire (10), selon l'une des revendications 7 à 14, comprenant la fabrication de composants électroniques dans ou sur la couche utile (1) de la structure composite (51), éventuellement après la croissance par épitaxie d'une couche supplémentaire sur la couche utile (1).

## Patentansprüche

1. Temporäres Substrat (10), das bei einer Entfernungstemperatur über 1000 °C entfernbar ist und umfassend:
- eine Halbleiternutzschicht (1), die sich entlang einer Hauptebene (x, y) erstreckt, - ein Trägersubstrat (3),
- eine Zwischenschicht (2), die zwischen der Nutzschicht (1) und dem Trägersubstrat (3) angeordnet ist und entlang einer Achse (z) senkrecht zu der Hauptebene (x, y) eine Dicke kleiner als 20 nm aufweist,
- eine Klebeschnittstelle (4), die sich in der Zwischenschicht (2) befindet oder an diese angrenzt,
- Atome (2a) mindestens einer gasförmigen Spezies, die gemäß einem Konzentrationsprofil (2b) entlang der Achse (z) senkrecht zu der Hauptebene (x, y) verteilt sind, mit einem Konzentrationsmaximum über 10²¹/cm³, wobei die Atome (2a) in der Zwischenschicht (2) und/oder in einer angrenzenden Schicht des Trägersubstrats (3) mit einer Dicke kleiner als oder gleich 10 nm und/oder in einer angrenzenden Unterschicht der Nutzschicht (1) mit einer Dicke kleiner als oder gleich 10 nm eingefangen bleiben, wenn das temporäre Substrat (10) einer Temperatur unter der Entfernungstemperatur ausgesetzt wird, und wobei die Atome (2a) dazu bestimmt sind, an einer Entfernungsschnittstelle zu diffundieren, wenn das temporäre Substrat (10) einer Temperatur größer als oder gleich der Entfernungstemperatur ausgesetzt wird.

2. Temporäres Substrat (10) nach dem vorstehenden Anspruch, wobei die Zwischenschicht (2) aus mindestens einem Material ausgebildet ist, das aus Wolfram, Nickel, Titan, Aluminium, Molybdän, Tantal, Titannitrid, Tantalnitrid, amorphem Silizium ausgewählt ist.

3. Temporäres Substrat (10) nach einem der vorstehenden Ansprüche, wobei die gasförmige Spezies Stickstoff, Helium, Argon, Xenon und/oder Wasserstoff ist.

4. Temporäres Substrat (10) nach einem der vorstehenden Ansprüche, wobei das Trägersubstrat (3) ein Material umfasst, dessen Wärmeausdehnungskoeffizient gleich oder nahe dem der Nutzschicht (1) ist.

5. Herstellungsverfahren für ein temporäres Substrat (10) entsprechend einem der vorstehenden Ansprüche, umfassend:
a) einen Schritt zum Bereitstellen eines Donorsubstrats (11),
b) einen Schritt zum Einbringen von leichten Ionen, die aus Wasserstoff, Helium oder einer Kombination der zwei ausgewählt sind, in das Donorsubstrat (11), zum Ausbilden einer verdeckten spröden Ebene (5) in dem Donorsubstrat (11), wobei die verdeckte spröde Ebene (5) eine oberflächliche Nutzschicht (1) mit einer Vorderseite (11a) des Donorsubstrats (11) begrenzt,
c) einen Schritt zum Bereitstellen eines Trägersubstrats (3), das eine Vorderseite (3a) aufweist,
d) einen Schritt zum Abscheiden mindestens eines Films (21, 22) auf die Vorderseite (11a) des Donorsubstrats (11) und/oder auf die Vorderseite (3a) des Trägersubstrats (3), wobei der - mindestens eine - Film dazu bestimmt ist, die Zwischenschicht (2) auszubilden,
e) Zusammenfügen des Donorsubstrats (11) und des Trägersubstrats (3), sodass der - mindestens eine - Film (21, 22) zum Ausbilden der Zwischenschicht (2) zwischen den Substraten (11, 3) angeordnet ist,
f) Trennen entlang der verdeckten spröden Ebene (5), zum Ausbilden einerseits des temporären Substrats (10) und andererseits des Rests des Donorsubstrats (11'),
das Herstellungsverfahren umfassend ferner einen Schritt zum Einführen von Atomen (2a) der - mindestens einen - gasförmigen Spezies:
- in das Donorsubstrat (11) und/oder in das Trägersubstrat (3) in einer Tiefe von 10 nm oder weniger, ausgehend von ihren jeweiligen Vorderseiten (11a, 3a), vor dem Schritt d) des Abscheidens, oder
- in den - mindestens einen - Film (21, 22), nach dem Schritt d) des Abscheidens, oder
- in die Zwischenschicht (2) nach dem Trennungsschritt f).

6. Herstellungsverfahren für ein temporäres Substrat (10) nach dem vorstehenden Anspruch, wobei der Schritt f) eine Wärmebehandlung bei einer Temperatur zwischen 900 °C und 1200 °C umfasst.

7. Verfahren zum Übertragen einer Nutzschicht (1) eines temporären Substrats (10) entsprechend einem der Ansprüche 1 bis 4 auf ein Empfängersubstrat (50), das Verfahren umfassend:
g) einen Schritt zum Ausbilden einer entfernbaren Struktur (510), umfassend ein Empfängersubstrat (50), das auf die Nutzschicht (1) des temporären Substrats (10) abgeschieden wird, wobei der Ausbildungsschritt eine Behandlung bei einer ersten Temperatur über oder gleich 1000 °C beinhaltet,
h) einen Schritt zum Ablösen der entfernbaren Struktur (510) entlang einer Ablösungsschnittstelle in oder angrenzend an die Zwischenschicht (2), der Ablösungsschritt umfassend eine Wärmebehandlung bei einer Ablösungstemperatur über der ersten Temperatur, zum Ausbilden einerseits einer Verbundstruktur (51), umfassend die Nutzschicht (1), die auf dem Empfängersubstrat (50) angeordnet ist, und andererseits des Trägersubstrats (3).

8. Verfahren zum Übertragen einer Nutzschicht (1) eines temporären Substrats (10) nach dem vorstehenden Anspruch, wobei Schritt g) das Abscheiden des Empfängersubstrats (50) auf eine freie Seite der Nutzschicht (1) des temporären Substrats (10) umfasst.

9. Verfahren zum Übertragen einer Nutzschicht (1) eines temporären Substrats (10) nach dem vorstehenden Anspruch, wobei das Abscheiden des Empfängersubstrats (50) durch thermische oder unterstützte chemische Gasphasenabscheidung oder durch Verdampfung bei einer Temperatur über oder gleich 1000 °C , vorzugsweise über oder gleich 1200 °C, erfolgt.

10. Verfahren zum Übertragen einer Nutzschicht (1) eines temporären Substrats (10) nach einem der zwei vorstehenden Ansprüche, wobei das ausgebildete Empfängersubstrat (50) aus polykristallinem Siliziumkarbid besteht.

11. Verfahren zum Übertragen einer Nutzschicht (1) eines temporären Substrats (10) nach einem der Ansprüche 7 bis 10, wobei Schritt h) eine Wärmebehandlung bei einer Temperatur über oder gleich 1400 °C, sogar über oder gleich 1500 °C, umfasst.

12. Verfahren zum Übertragen einer Nutzschicht (1) eines temporären Substrats (10) nach einem der Ansprüche 7 bis 11, umfassend einen Schritt i) zum Endbearbeiten der Verbundstruktur (51), der eine chemische Reinigung und/oder ein chemisches Ätzen und/oder ein chemisch-mechanisches Polieren der freien Seite der Nutzschicht (1), der Vorderseite (51a) der Verbundstruktur (51), einschließt.

13. Verfahren zum Übertragen einer Nutzschicht (1) eines temporären Substrats (10) nach dem vorstehenden Anspruch, wobei Schritt i) eine chemische Reinigung und/oder ein chemisches Ätzen und/oder ein mechanisches Läppen und/oder ein chemisch-mechanisches Polieren der freien Seite des Empfängersubstrats (50), der Rückseite (50b) der Verbundstruktur (51), umfasst.

14. Verfahren zum Übertragen einer Nutzschicht (1) eines temporären Substrats (10) nach einem der Ansprüche 7 bis 13, umfassend einen Schritt g') zum Behandeln der entfernbaren Struktur (510) vor dem Schritt h) des Ablösens, der eine chemische Reinigung und/oder ein chemisches Ätzen und/oder ein mechanisches Läppen und/oder ein chemisch-mechanisches Polieren der Rückseite (50b) des Empfangssubstrats (50) einschließt.

15. Verfahren zum Übertragen einer Nutzschicht (1) eines temporären Substrats (10) nach einem der Ansprüche 7 bis 14, umfassend das Herstellen von elektronischen Komponenten in oder auf der Nutzschicht (1) der Verbundstruktur (51), gegebenenfalls nach dem epitaktischen Wachstum einer zusätzlichen Schicht auf der Nutzschicht (1).

## Claims

1. Temporary substrate (10), removable at a removal temperature of above 1000°C and comprising:
- a useful semiconductor layer (1) extending along a main plane (x,y),
- a support substrate (3),
- an intermediate layer (2) arranged between the useful layer (1) and the support substrate (3), having a thickness of less than 20 nm along an axis (z) normal to the main plane (x,y),
- a bonding interface (4) located in or adjacent to the intermediate layer (2),
- atoms (2a) of at least one gaseous species which are distributed according to a concentration profile (2b) along the axis (z) normal to the main plane (x,y), with a concentration maximum greater than 10²¹/cm³, said atoms (2a) remaining trapped in the intermediate layer (2) and/or in an adjacent layer of the support substrate (3) of a thickness less than or equal to 10 nm and/or in an adjacent sub-layer of the useful layer (1) of a thickness less than or equal to 10 nm, when the temporary substrate (10) is subjected to a temperature lower than the removal temperature, and said atoms (2a) being intended to diffuse at a detachment interface when the temporary substrate (10) is subjected to a temperature greater than or equal to the removal temperature.

2. Temporary substrate (10) according to the preceding claim, wherein the intermediate layer (2) is formed by at least one material selected from tungsten, nickel, titanium, aluminum, molybdenum, tantalum, titanium nitride, tantalum nitride and amorphous silicon.

3. Temporary substrate (10) according to one of the preceding claims, wherein the gaseous species is nitrogen, helium, argon, xenon and/or hydrogen.

4. Temporary substrate (10) according to one of the preceding claims, wherein the support substrate (3) comprises a material of which the coefficient of thermal expansion is equal to or close to that of the useful layer (1).

5. Method for producing a temporary substrate (10) according to one of the preceding claims, comprising:
a) a step of providing a donor substrate (11),
b) a step of implanting light ions selected from hydrogen, helium or a combination of both into the donor substrate (11), to form a buried brittle plane (5) in said donor substrate (11), the buried brittle plane (5) delimiting a surface useful layer (1) with a front face (11a) of the donor substrate (11),
c) a step of providing a support substrate (3) having a front face (3a),
d) a step of depositing at least one film (21, 22) onto the front face (11a) of the donor substrate (11) and/or on the front face (3a) of the support substrate (3), the - at least one - film being intended to form the intermediate layer (2),
e) joining the donor substrate (11) and the support substrate (3) such that the - at least one - film (21, 22) is arranged between said substrates (11, 3) to form the intermediate layer (2),
f) separation along the buried brittle plane (5), to form, on the one hand the temporary substrate (10), and on the other hand the remainder of the donor substrate (11'),
the production method further comprising a step of introducing atoms (2a) of the - at least one - gaseous species:
- into the donor substrate (11) and/or into the support substrate (3), to a depth of less than or equal to 10 nm from their respective front faces (11a, 3a), prior to the deposition step d), or
- into the - at least one - film (21, 22), after the deposition step d), or
- into the intermediate layer (2), after the separation step f).

6. Method for producing a temporary substrate (10), according to the preceding claim, wherein step f) comprises a heat treatment at a temperature between 900°C and 1200°C.

7. Method for transferring a useful layer (1) of a temporary substrate (10) according to one of claims 1 to 4, onto a receiver substrate (50), the method comprising:
g) a step of forming a removable structure (510) comprising a receiver substrate (50) arranged on the useful layer (1) of the temporary substrate (10), the forming step involving treatment at a first temperature which is greater than or equal to 1000°C,
h) a step of detaching the removable structure (510) along a detachment interface in or adjacent to the intermediate layer (2), the detachment step comprising a heat treatment at a removal temperature greater than the first temperature, in order to form, on the one hand, a composite structure (51) which comprises the useful layer (1) arranged on the receiver substrate (50), and, on the other hand, the support substrate (3).

8. Method for transferring a useful layer (1) of a temporary substrate (10), according to the preceding claim, wherein step g) comprises depositing the receiver substrate (50) onto a free face of the useful layer (1) of the temporary substrate (10).

9. Method for transferring a useful layer (1) of a temporary substrate (10), according to the preceding claim, wherein the deposition of the receiver substrate (50) is carried out by thermal or assisted chemical vapor deposition, or by evaporation, at a temperature greater than or equal to 1000°C, preferably greater than or equal to 1200°C.

10. Method for transferring a useful layer (1) of a temporary substrate (10), according to one of the two preceding claims, wherein the formed receiver substrate (50) is made of polycrystalline silicon carbide.

11. Method for transferring a useful layer (1) of a temporary substrate (10), according to one of claims 7 to 10, wherein step h) comprises heat treatment at a temperature greater than or equal to 1400°C, or greater than or equal to 1500°C.

12. Method for transferring a useful layer (1) of a temporary substrate (10), according to one of claims 7 to 11, comprising a step i) of finishing the composite structure (51), including chemical cleaning and/or chemical etching and/or chemical-mechanical polishing of the free face of the useful layer (1), the front face (51a) of the composite structure (51).

13. Method for transferring a useful layer (1) of a temporary substrate (10), according to the preceding claim, wherein step i) comprises chemical cleaning and/or chemical etching and/or mechanical grinding and/or chemical-mechanical polishing of the free face of the receiver substrate (50), the rear face (50b) of the composite structure (51).

14. Method for transferring a useful layer (1) of a temporary substrate (10), according to one of claims 7 to 13, comprising a step g') of treating the removable structure (510), prior to the detachment step h), including chemical cleaning and/or chemical etching and/or mechanical grinding and/or chemical-mechanical polishing of the rear face (50b) of the receiver substrate (50).

15. Method for transferring a useful layer (1) of a temporary substrate (10), according to one of claims 7 to 14, comprising the production of electronic components in or on the useful layer (1) of the composite structure (51), optionally after epitaxial growth of an additional layer on the useful layer (1).
